(19) Europäisches Patentamt
European Patent Office
Office européen des brevets

(11) **EP 1 238 431 B1**

(12) **FASCICULE DE BREVET EUROPEEN**

(45) Date de publication et mention
de la délivrance du brevet:
**01.04.2015 Bulletin 2015/14**

(51) Int Cl.:
*H01L 23/522* *(2006.01)*      *H05K 1/18* *(2006.01)*
*H05K 3/40* *(2006.01)*         *H05K 1/02* *(2006.01)*
*H05K 3/04* *(2006.01)*

(21) Numéro de dépôt: **00993460.5**

(22) Date de dépôt: **12.12.2000**

(86) Numéro de dépôt international:
**PCT/FR2000/003486**

(87) Numéro de publication internationale:
**WO 2001/045172 (21.06.2001 Gazette 2001/25)**

(54) **PROCEDE ET DISPOSITIF D'INTERCONNEXION EN TROIS DIMENSIONS DE COMPOSANTS ELECTRONIQUES**

VERFAHREN UND VORRICHTUNG ZUR DREIDIMENSIONALEN VERBINDUNG ELEKTRONISCHER KOMPONENTEN

METHOD AND DEVICE FOR INTERCONNECTING ELECTRONIC COMPONENTS IN THREE DIMENSIONS

(84) Etats contractants désignés:
**DE GB IT**

(30) Priorité: **15.12.1999 FR 9915838**

(43) Date de publication de la demande:
**11.09.2002 Bulletin 2002/37**

(60) Demande divisionnaire:
**09172209.0 / 2 136 401**

(73) Titulaire: **3D Plus**
**78530 Buc (FR)**

(72) Inventeur: **Val, Christian**
**Thales Intellectual Property**
**94117 Arcueil Cedex (FR)**

(74) Mandataire: **Henriot, Marie-Pierre**
**Marks & Clerk France**
**Conseils en Propriété Industrielle**
**Immeuble Visium**
**22, Avenue Aristide Briand**
**94117 Arcueil Cedex (FR)**

(56) Documents cités:
EP-A- 0 490 739      EP-A- 0 593 330
EP-A- 0 638 933      WO-A-95/25341
FR-A- 2 529 386      FR-A- 2 645 681
FR-A- 2 726 941

• P SINGER: "Making the Move to Dual Damascene Processing" SEMICONDUCTOR INTERNATIONAL,US,NEWTON, MAS, IL, vol. 20, no. 9, août 1997 (1997-08), pages 79-80,82, XP002114089 ISSN: 0163-3767
• S.F. AL-SARAWI ET AL: "a review of 3-d packaging technology" IEEE TRANSACTIONS ON COMPONENTS, PACKAGING AND MANUFACTURING TECHNOLOGY. PART B: ADVANCED PACKAGING., vol. 21, no. 1, février 1998 (1998-02), pages 2-14, XP002162813 IEEE SERVICE CENTER, PISCATAWAY, NJ., US ISSN: 1070-9894

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

## Description

L'invention se rapporte à un procédé d'interconnexion en trois dimensions de boîtiers ou circuits contenant au moins un composant électronique.

La réalisation des systèmes électroniques actuels doit tenir compte d'exigences de plus en plus grandes en termes de compacité, du fait du nombre de plus en plus élevé de circuits mis en oeuvre, et de rapidité de fonctionnement. Dans un but de compacité, il a déjà été proposé de réaliser des empilements de puces de circuits intégrés, comme décrit dans le brevet français FR 2 670 323, ou de boîtiers encapsulant des pastilles semiconductrices, comme décrit dans le brevet français FR 2 688 630, l'interconnexion des puces ou boîtiers s'effectuant en trois dimensions en utilisant les faces de l'empilement comme surfaces d'interconnexion.

Cependant, comme ces blocs de boîtiers ou circuits empilés sont ensuite généralement enrobés d'un matériau électriquement isolant puis blindés par dépôt d'une couche de métallisation, il existe des capacités parasites non négligeables entre les connexions tracées sur les surfaces de l'empilement et le blindage. Ceci constitue un inconvénient important, notamment dans la recherche de la rapidité de fonctionnement des composants.

La présente invention a pour objet de remédier à cet inconvénient en interconnectant les conducteurs des boîtiers ou circuits non plus par des connexions tracées sur les surfaces du bloc mais par des connexions empruntant des rainures perpendiculaires à la face du bloc.

Selon l'invention, il est donc prévu un procédé d'interconnexion en trois dimensions de boîtiers ou circuits contenant au moins un composant électronique et munis de conducteurs de connexion, dans lequel lesdits boîtiers ou circuits sont empilés et solidarisés par enrobage à l'aide d'un matériau électriquement isolant pour former un bloc, ledit procédé étant caractérisé en ce qu'il comporte les étapes suivantes :

a) découpe du bloc en laissant les extrémités des conducteurs en retrait par rapport aux faces correspondantes du bloc ;
b) découpe dans les faces du bloc en vis-à-vis des extrémités des conducteurs et perpendiculairement à celles-ci de rainures venant au contact desdits conducteurs sur une profondeur suffisante pour entamer l'extrémité desdits conducteurs ;
c) métallisation du bloc et de ses rainures ;
d) polissage desdites faces du bloc pour éliminer la métallisation de ces faces ;
e) enrobage de l'ensemble du bloc par un matériau électriquement isolant ;

et en ce que ledit procédé comprend en outre, entre les étapes c) et e), l'insertion d'une étape de découpe, dans le fond desdites rainures prédéterminées et sur toute leur longueur, de secondes rainures.

L'invention prévoit également un dispositif électronique à interconnexion en trois dimensions comportant des boîtiers ou circuits contenant au moins un composant électronique et munis de conducteurs de connexion, dans lequel lesdits boîtiers ou circuits sont empilés et enrobés par un matériau électriquement isolant pour former un bloc dont les faces en vis-à-vis des extrémités desdits conducteurs comportent des premières rainures au contact de ceux-ci, caractérisé en ce que les extrémités desdits conducteurs sont en retrait par rapport auxdites faces en vis-à-vis du bloc, en ce que lesdites faces comportent des premières rainures, qui ont une profondeur suffisante pour entamer les extrémités respectives desdits conducteurs et dont les faces portent une métallisation en contact avec lesdits conducteurs, et en ce qu'il comporte au fond de ces premières rainures et sur toute leur longueur, des deuxièmes rainures sans métallisation, et en ce que ledit bloc comporte un matériau électriquement isolant enrobant l'ensemble du bloc et des rainures.

Grâce à ces dispositions, seules les sections des métallisations des rainures affleurent à la surface du bloc vis-à-vis de la métallisation de blindage, d'où une diminution considérable des capacités parasites. En outre, le fait que l'ensemble des surfaces latérales internes des rainures soient métallisées et participent à la conduction accroît notablement la section des connexions et donc les possibilités d'acheminement de courants importants sans pour autant augmenter l'écartement des connexions.

Un autre aspect de l'invention consiste à profiter des rainures ainsi obtenues pour réaliser des barres omnibus d'alimentation ("Bus bar" dans la littérature anglosaxonne) à condensateur réparti en formant, par découpe du fond d'une rainure, deux électrodes se faisant face pour le réseau Masse-Alimentation.

On peut ainsi obtenir des modules avec barre omnibus intégrée ou reportée d'encombrement réduit et à faible coût.

L'invention sera mieux comprise et d'autres caractéristiques et avantages apparaîtront à l'aide de la description ci-après et des dessins joints où :

- les figures 1 à 3 représentent un dispositif à interconnexion en trois dimensions de type connu ;
- la figure 4 montre l'organigramme de certaines étapes de réalisation du procédé selon l'invention ;
- la figure 5 représente une étape de fabrication du dispositif selon l'invention ;
- la figure 6 représente une autre étape de fabrication du dispositif selon l'invention;
- les figures 7A et 7B montrent un détail de variantes du dispositif selon l'invention ;
- la figure 8 montre l'organigramme d'un mode de réalisation du procédé selon l'invention ;
- la figure 9 illustre une étape de la fabrication d'un dispositif selon le procédé de la figure 8 ;

- la figure 10 est une vue partielle du dispositif selon l'invention obtenu selon ce procédé.
- la figure 11 représente le dispositif selon l'invention obtenu selon ce procédé dans une autre application ; et
- la figure 12 est une vue d'une variante du dispositif de la figure 10.

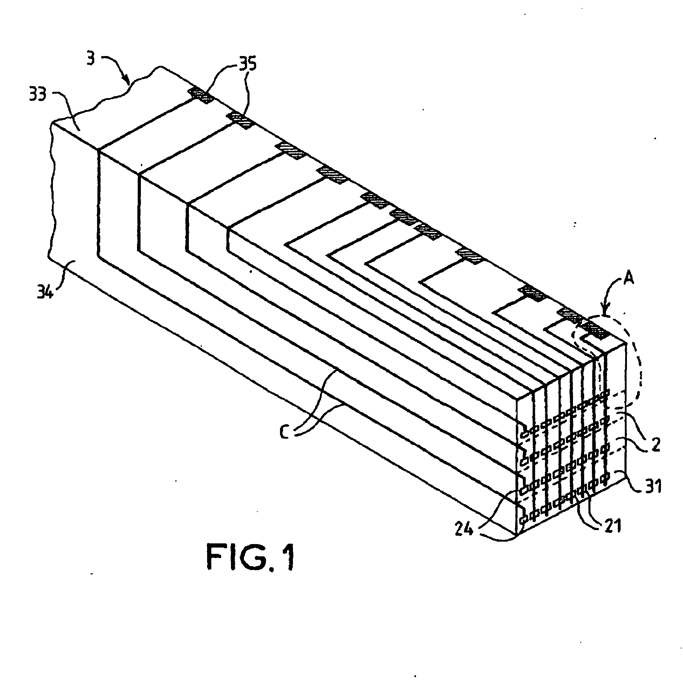

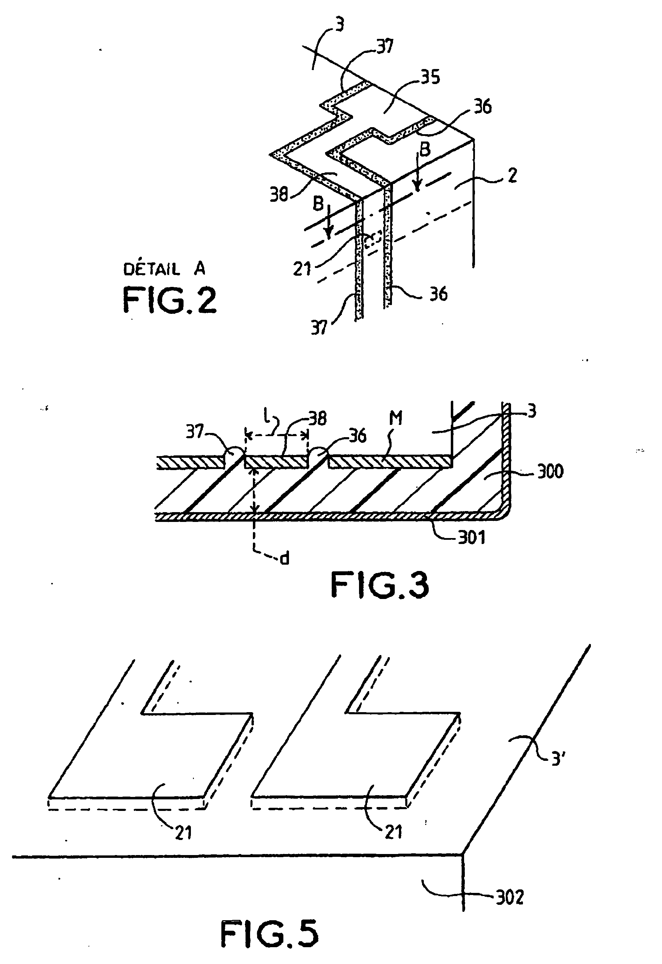

La figure 1 représente une vue partielle d'un dispositif à interconnexions en trois dimensions connu selon le brevet FR 2 688 630, la figure 2 un détail A de la figure 1 et la figure 3 une coupe selon B-B de la figure 2.

Ce dispositif connu est formé par empilement de boîtiers ou circuits 2 munis de conducteurs de connexion 21 et solidarisation par enrobage à l'aide d'un matériau électriquement isolant de manière à former un bloc 3. Ce matériau est choisi de préférence pour qu'il soit thermo-mécaniquement adapté au matériau formant le boîtier ou le circuit de façon à faciliter la dissipation thermique et à éviter les contraintes ou ruptures éventuelles dues à des différences trop grandes dans les valeurs des coefficients de dilatation des matériaux. On peut utiliser par exemple une résine polymérisable telle qu'une résine époxy.

Le bloc est découpé et poli pour former des faces 31, 33, 34, de manière telle que les conducteurs de connexion des boîtiers affleurent les faces correspondantes du bloc (face 31 sur la figure 1). Une métallisation est ensuite réalisée sur l'ensemble des faces du bloc puis les connexions C sont découpées par exemple par gravure laser.

Sur la figure 2 est montré le détail A de la figure 1. On y voit une connexion 38 entre les conducteurs adéquats 21 des différents boîtiers, cette connexion aboutissant à un plot 35 pour la liaison électrique à des circuits extérieurs.

La connexion 38 et le plot 35 sont obtenus par gravure 36, 37, par exemple par laser, détruisant localement la couche de métallisation conductrice M.

La coupe selon B-B de la figure 3 illustre le dispositif terminé.

Le bloc 3 avec la métallisation M, les gravures 36 et 37 et la connexion 38 de largeur $\ell$ est enrobé dans un matériau électriquement isolant 300 sur une épaisseur $d$ et une métallisation de blindage 301 est déposée sur l'ensemble.

On peut constater que, du fait que l'épaisseur $d$ est faible, une capacité parasite non négligeable apparaît entre la connexion 38 et la métallisation 301. Cette capacité est de la forme :

$$C = \varepsilon_v \, \varepsilon_0 \, \frac{A}{d}$$

où A est l'aire des surfaces en regard, $\varepsilon_0$ = 8,86.10$^{-12}$ F/m et $\varepsilon_v$ est la permittivité du matériau 300 enrobant le bloc (par exemple de l'ordre de 4).

Par exemple, si l'on suppose une largeur $\ell$ de connexion égale à 350 $\mu$m et une épaisseur $d$ égale à 100 $\mu$m, pour une longueur de connexion unité, 1 mm, on obtient :

$$C = 12{,}4.10^{-14} \ F$$

soit environ 0,125 pF par mm.

Pour une longueur de connexion 38 de 10 mm, on obtient déjà une capacité parasite de 1,25 pF, ce qui peut constituer un inconvénient important pour des circuits fonctionnant de plus en plus rapidement avec des tensions d'alimentation réduites.

La solution selon l'invention consiste à réduire dans de larges proportions les surfaces en regard des connexions et du blindage, ce qui réduit notablement les capacités parasites.

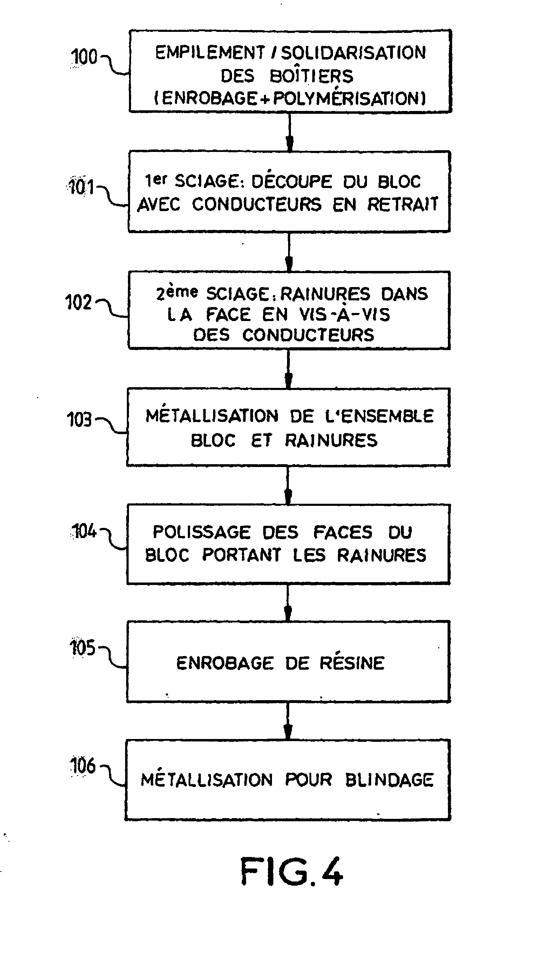

La figure 4 illustre donc certaines étapes d'un mode de réalisation du procédé selon l'invention.

La première étape du procédé, 100, ne change pas par rapport à l'art antérieur. On empile les boîtiers ou circuits et on les solidarise par enrobage de l'ensemble par un matériau électriquement isolant, tel qu'une résine qu'on polymérise.

L'étape suivante 101 consiste à découper l'empilement solidarisé de sorte que les conducteurs de connexion 21 des boîtiers ou circuits soient en retrait par rapport à la face correspondante du bloc. Ceci est représenté sur la figure 5. On y voit le bloc 3' obtenu après l'étape 101 avec les extrémités des conducteurs 21 du boîtier supérieur. Le plan de découpe, par exemple par sciage, est matérialisé par la face 302 du bloc 3'.

Le retrait des conducteurs 21 par rapport à la face 302 peut être de quelques micromètres à quelques centaines de micromètres.

L'étape suivante 102 consiste à réaliser des rainures perpendiculaires à la face 302 et au plan des boîtiers sur une profondeur suffisante pour entamer l'extrémité des conducteurs 21 en retrait. On obtient ainsi une section qui pourra être métallisée.

L'étape suivante 103 consiste à déposer une (ou plusieurs) couche(s) conductrice(s), métallique(s) par exemple, sur l'ensemble des faces du bloc 3' et des rainures précédemment réalisées.

L'étape suivante 104 consiste en un polissage des faces du bloc comportant des rainures pour dé-courtcircuiter les connexions réalisées dans les rainures.

L'étape suivante 105 consiste à enrober l'ensemble dans un matériau électriquement isolant tel qu'une résine polymérisable. Enfin, l'étape 106 comporte la métallisation de l'ensemble enrobé pour réaliser un blindage.

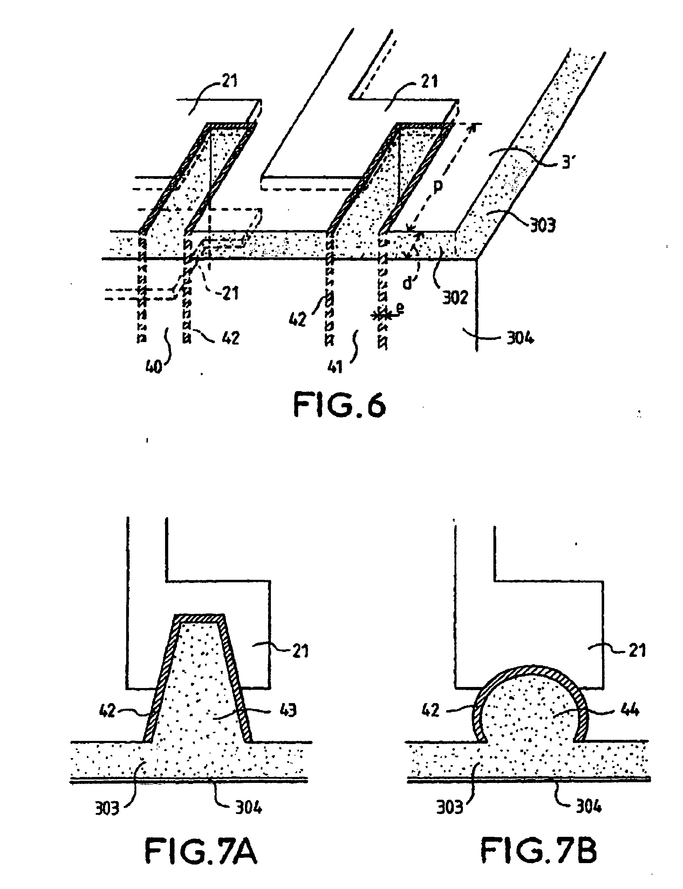

La figure 6 représente partiellement le dispositif selon l'invention. On y retrouve les conducteurs 21 et la face 302 du bloc 3' de la figure 5. Des rainures 40, 41 entaillent la face 302 jusqu'aux conducteurs 21. La métallisation des rainures 42 est celle qui subsiste après l'étape 104 de polissage de la face 302 qui enlève la métallisation sur cette face. La métallisation restante 42 assure la connexion entre les conducteurs correspondants des divers boîtiers. Le bloc 3' est enrobé par une résine 303 après l'étape 105, laquelle est recouverte d'une métallisation de blindage 304. Les deuxièmes rainures ne sont pas représentées sur cette figure.

Les rainures peuvent être réalisées dans l'étape 102 par sciage, fraisage, par gravure laser ou tout autre technique connue.

Comme on peut le constater sur la figure 6, les capacités parasites sont maintenant pratiquement exclusivement celles existant entre les sections de métallisation 42 affleurant la face 302 et le blindage 304. Elles sont de la forme :

$$C = 2\varepsilon_v \ \varepsilon_0 \ \frac{A'}{d}$$

L'aire A' est égale à <u>e</u> par millimètre de connexion.

Si on suppose une épaisseur <u>e</u> de 7 $\mu$m, on obtient alors une capacité de l'ordre de 0,005pF/mm, c'est-à-dire 0,05pF pour une longueur de connexion de 10 mm. On peut ainsi constater qu'on a divisé par 25 la capacité parasite.

Les figures 7A et 7B montrent d'autres formes de rainures obtenues selon la technique de découpe utilisée. Sur la figure 7A, la section des rainures 43 est trapézoïdale et, sur la figure 7B, la section des rainures 44 est partiellement circulaire.

Le procédé permet de réaliser des barres omnibus d'alimentation avec condensateur réparti intégré ou reporté.

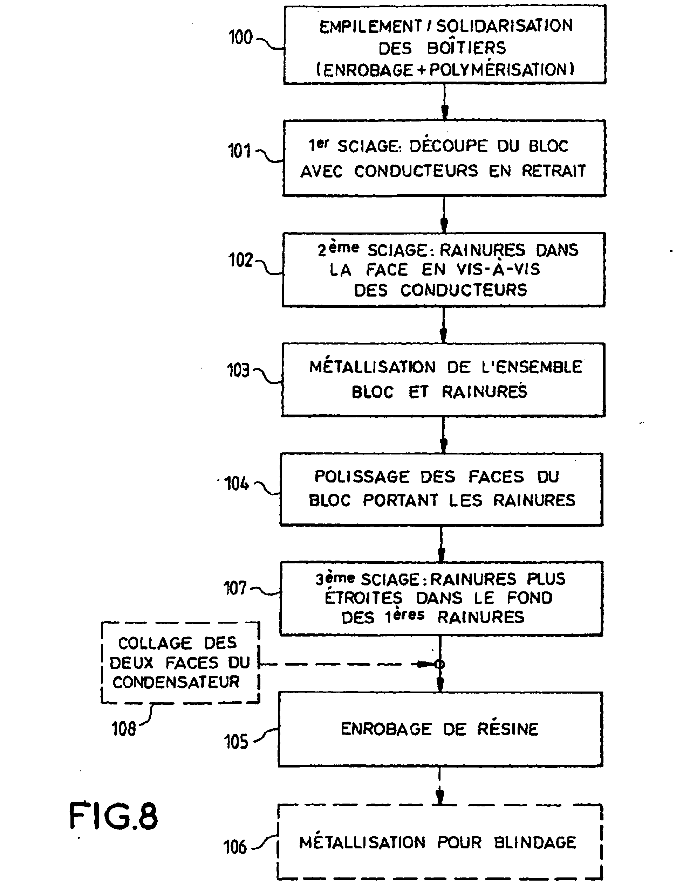

La figure 8 illustre ce procédé selon l'invention. Par rapport au procédé de la figure 4, on a tout d'abord prévu que l'étape 102 de découpe de rainures devait, pour des rainures prédéterminées devant former lesdites barres, permettre d'entamer deux conducteurs adjacents d'alimentation desdits boîtiers. D'autre part, on a prévu d'insérer, entre l'étape 103 et l'étape 105, une étape 107 de découpe, dans le fond de ces rainures prédéterminées et sur toute leur longueur, de secondes rainures pour séparer ainsi deux électrodes Masse et Alimentation.

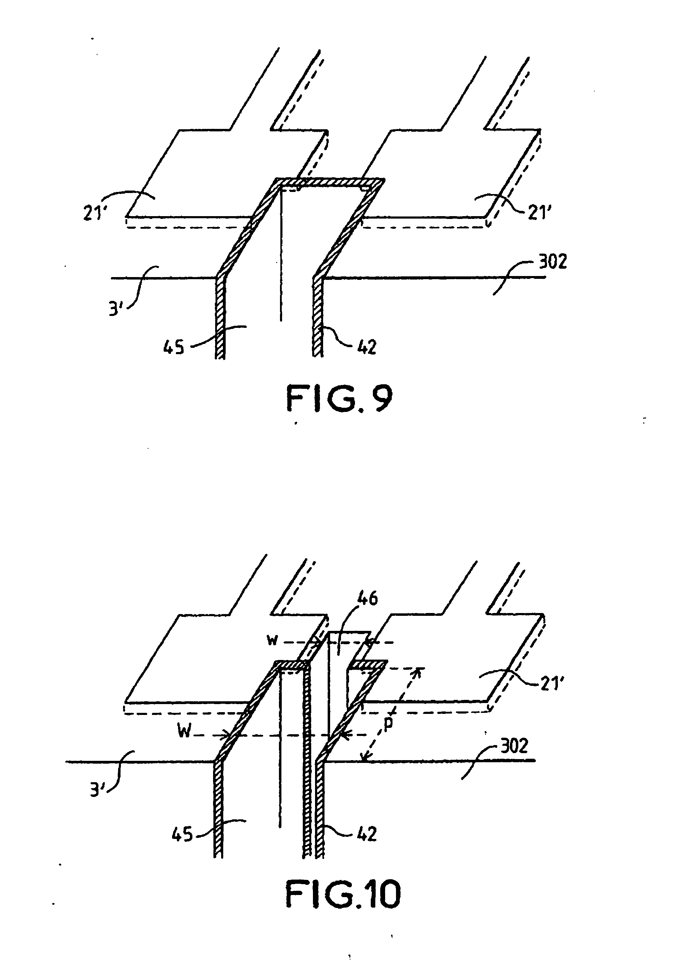

La figure 9 est une vue partielle du dispositif après l'étape 104. La rainure 45 entame deux conducteurs adjacents 21' du bloc 3' et ses faces ont une métallisation 42 affleurant la face polie 302.

La figure 10 montre une vue partielle après l'étape 107.

La seconde rainure 46 de largeur <u>w</u> inférieure à la largeur W de la rainure 45 a découpé la métallisation 42 pour former deux électrodes se faisant face.

L'étape 105 (figure 8) consiste ensuite à enrober l'ensemble bloc 3' - rainures 45,46 à l'aide d'un matériau électriquement isolant tel qu'une résine organique polymérisable. Ceci a pour but tout d'abord de refermer les rainures pour éviter que des poussières ou résidus de flux lors de brasage ne viennent polluer les conducteurs, connexions et électrodes. Cela permet ensuite de redéposer un dépôt métallique comme blindage de l'ensemble du module selon l'étape 106 facultative, si un blindage est nécessaire.

Enfin, cela permet d'obtenir une capacité répartie le long des deux électrodes. Habituellement, on utilise une résine époxy très chargée en particules minérales afin de réduire son coefficient de dilatation. On obtient une permittivité de l'ordre de 4. Dans ces conditions, avec une profondeur p de rainure de 1 mm et une largeur W de 200 $\mu$m, on a une capacité de l'ordre de 0,177 pF/mm. Avec une rainure de longueur 10 mm, on obtient une capacité de l'ordre de 1,77 pF.

Cependant, pour certaines applications, on peut utiliser une résine chargée en particules diélectriques, par exemple du titanate de baryum, pour atteindre des permittivités beaucoup plus élevées (typiquement quelques centaines). Ainsi avec une permittivité $\varepsilon_v = 400$, on obtiendrait une capacité de l'ordre de 177 pF.

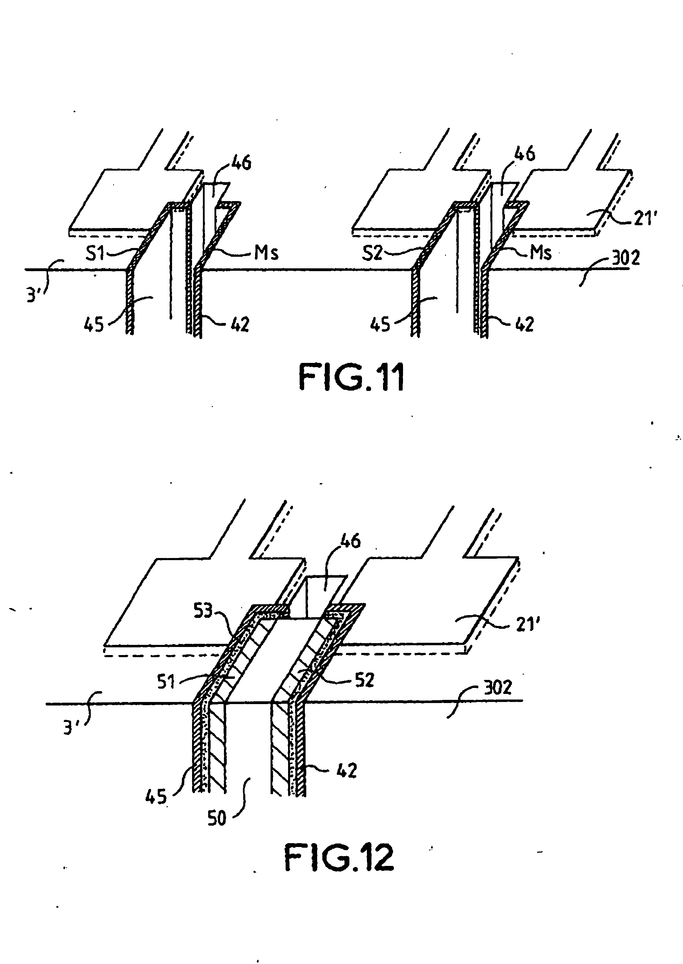

L'obtention dans une rainure 45 de deux électrodes se faisant face, comme représenté sur la figure 10, outre l'application indiquée ci-dessus pour réaliser des électrodes Masse et Alimentation, peut conduire à d'autres applications et, en particulier, celle illustrée sur la figure 11.

En effet, aux fréquences élevées, il peut exister entre deux connexions voisines de signal une diaphonie, c'est-à-dire l'induction d'un courant parasite d'une connexion sur la connexion adjacente. Avec des connexions réalisées sous forme coplanaire (sans rainures), on peut arriver à réduire la diaphonie en séparant les connexions par une connexion (également coplanaire) de masse. Mais ceci oblige à accroître notablement le pas des connexions de signal.

Le dispositif selon l'invention permet de remédier avantageusement à cet inconvénient, comme on le voit sur la figure 11. On y voit que, dans chaque rainure 45, une des électrodes, Ms, peut être reliée à la masse, de telle sorte que les électrodes de signal S1, S2 sont séparées l'une de l'autre par un blindage ou plan masse Ms. Les électrodes Ms peuvent être reliées à des conducteurs 21', comme à droite sur la figure 11, ou bien servir seulement de blindage en étant reliée à la masse sans être connectée à des conducteurs 21', comme à gauche sur la figure 11.

Une autre possibilité offerte par le dispositif de la figure 10 est la réalisation d'une barre omnibus d'alimentation avec condensateur reporté comme représenté sur la figure 12. Dans cette réalisation, on insère dans la rainure 45 un condensateur 50 comportant des métallisations formant électrodes 51, 52 sur deux faces opposées longitudinales. Ces faces sont disposées en regard des métallisations 42 formant les deux électrodes de la connexion et on relie entre elles les électrodes correspondantes, tout en fixant le condensateur, à l'aide d'un matériau électriquement conducteur, par exemple par collage avec une colle chargée en argent 53. Ceci permet de gagner en encombrement et d'avoir un dispositif protégé contre les courts-circuits et les pollutions grâce à l'enrobage de l'ensemble. En outre, cela permet de minimiser les self-inductances pour l'alimentation des différents étages empilés du bloc, car chaque étage est relié directement au condensateur 10, et d'équilibrer au mieux l'alimentation de tous les étages. L'insertion du condensateur est représentée par l'étape 108 sur la figure 8.

On peut remarquer que l'ordre des étapes 104 et 107 est interchangeable dans le schéma du procédé de la figure 8. Cependant, l'ordre indiqué sur cette figure est préférentiel car cela évite que des poussières conductrices résultant de l'opération 104 viennent se loger dans les secondes rainures 46.

Bien entendu, les exemples de réalisation décrits ne sont nullement limitatifs de l'invention ; notamment les connexions à réaliser sur les autres faces du bloc que celles où se trouvent les conducteurs de connexion 21, 21' peuvent aussi être réalisées sur le même principe de découpe de rainures pour limiter les capacités parasites.

## Revendications

1.  Procédé d'interconnexion en trois dimensions de boîtiers ou circuits contenant au moins un composant électronique et munis de conducteurs de connexion, dans lequel lesdits boîtiers ou circuits sont empilés et solidarisés (100) par enrobage à l'aide d'un matériau électriquement isolant pour former un bloc (3, 3'), ledit procédé comportant les étapes suivantes :

    a) découpe du bloc;
    b) découpe dans les faces du bloc en vis-à-vis des extrémités des conducteurs et perpendiculairement à celles-ci de rainures venant au contact desdits conducteurs ;
    c) métallisation (103) du bloc et de ses rainures ;
    d) polissage (104) desdites faces du bloc pour éliminer la métallisation de ces faces ;
    e) enrobage (105) de l'ensemble du bloc par un matériau électriquement isolant ;

    ledit procédé étant **caractérisé en ce que** la découpe (101) de l'étape a) est effectuée en laissant les extrémités des conducteurs en retrait par rapport aux faces (302) correspondantes du bloc et **en ce que** la découpe (102) de rainures (40, 41 ; 43 ; 44) de l'étape b) est réalisée sur une profondeur suffisante pour entamer respectivement l'extrémité desdits conducteurs et en qu'il comprend en outre, entre les étapes c) et e), l'insertion d'une étape de :

    g)découpe (107), dans le fond desdites rainures et sur toute leur longueur, de secondes rainures (46).

2.  Procédé selon la revendication 1, **caractérisé en ce qu'**il comporte en outre une étape finale de :

    f) métallisation (106) du bloc pour assurer son blindage.

3.  Procédé selon l'une des revendications 1 ou 2, incluant la réalisation, pour l'alimentation desdits boîtiers ou circuits, de barres omnibus d'alimentation, **caractérisé en ce que**, lors de l'étape b), au moins l'une prédéterminée desdites rainures (45) vient entamer l'extrémité de deux conducteurs adjacents d'alimentation desdits boîtiers ou circuits.

4.  Procédé selon la revendication 3, **caractérisé en ce que** lesdites secondes rainures (46) ont une largeur inférieure à celle des rainures prédéterminées (45).

5.  Procédé selon l'une quelconque des revendications précédentes, **caractérisé en ce que** lesdites découpes de rainures (40, 41 ; 43 ; 44 ; 45, 46) sont réalisées par sciage.

6.  Procédé selon l'une quelconque des revendications 1 à 4, **caractérisé en ce que** lesdites découpes de rainures (40, 41 ; 43 ; 44 ; 45, 46) sont réalisées à l'aide d'un laser.

7.  Procédé selon l'une des revendications 3 ou 4, **caractérisé en ce que**, juste avant l'étape e) d'enrobage, il est prévu une étape supplémentaire de :

    h) introduction, entre les faces latérales d'au moins une desdites rainures prédéterminées, d'un condensateur et collage sur chacune desdites faces latérales à l'aide d'une colle conductrice.

8.  Dispositif électronique à interconnexion en trois dimensions comportant des boîtiers ou circuits contenant au moins un composant électronique et munis de conducteurs de connexion, dans lequel lesdits boîtiers ou circuits sont empilés et enrobés par un matériau électriquement isolant pour former un bloc (3, 3') dont les faces en vis-à-vis des extrémités desdits conducteurs comportent des premières rainures au contact de ceux-ci, **caractérisé en ce que** les extrémités desdits conducteurs (21 ; 21') sont en retrait par rapport auxdites faces en vis-à-vis du bloc, **en ce que** lesdites faces (302) comportent des premières rainures (40, 41 ; 43 ; 44 ; 45), qui ont une profondeur suffisante pour entamer les extrémités respectives desdits conducteurs (21 ; 21') et dont les faces portent une métallisation (42) en contact avec lesdits conducteurs, et **en ce qu'**il comporte au fond de ces premières rainures et sur toute leur longueur, des deuxièmes rainures (46) sans métallisation, et **en ce que** ledit bloc comporte un matériau électriquement isolant (303) enrobant l'ensemble du bloc (3 ; 3') et des rainures.

9. Dispositif selon la revendication 8, **caractérisé en ce que** ledit bloc (3, 3') comporte en outre une couche métallique de blindage (304) recouvrant le matériau électriquement isolant (303) d'enrobage de l'ensemble.

10. Dispositif selon l'une des revendications 8 ou 9, **caractérisé en ce que** des premières rainures prédéterminées (45) entament les extrémités de deux conducteurs adjacents (21').

11. Dispositif selon la revendication 10, **caractérisé en ce que**, entre les faces latérales d'au moins une desdites premières rainures prédéterminées (45), est disposé un condensateur fixé à ces faces latérales par un matériau conducteur électriquement.

## Patentansprüche

1. Verfahren zum dreidimensionalen Verbinden von Modulen oder Schaltungen, die wenigstens eine elektronische Komponente enthalten und mit Verbindungsleitern versehen sind, bei dem die Module oder Schaltungen durch Verkapseln mit einem elektrisch isolierenden Material gestapelt und integriert (100) werden, um einen Block (3, 3') zu bilden, wobei das Verfahren die folgenden Schritte beinhaltet:

   a) Schneiden des Blocks;
   b) Schneiden von Nuten in die Flächen des Blocks, die den Enden der Leiter gegenüberliegen und lotrecht dazu sind, wobei die Nuten mit den Leitern in Kontakt kommen;
   c) Metallisieren (103) des Blocks und seiner Nuten;
   d) Polieren (104) der Flächen des Blocks, um die Metallisierung von diesen Flächen zu entfernen;
   e) Verkapseln (105) des gesamten Blocks mit einem elektrisch isolierenden Material;

   wobei das Verfahren **dadurch gekennzeichnet** ist, dass das Schneiden (101) von Schritt a) durch Zurückgesetztlassen der Enden der Leiter in Bezug auf die entsprechenden Flächen (302) des Blocks ausgeführt wird, und dadurch, dass das Schneiden (102) der Nuten (40, 41; 43; 44) in Schritt b) bis in eine Tiefe erfolgt, die ausreicht, um jeweils in das Ende der Leiter zu schneiden, und dadurch, dass es ferner zwischen den Schritten c) und e) das Einführen des folgenden Schrittes beinhaltet:

   g) Schneiden (107), in den Boden und über die gesamte Länge der Nuten, von zweiten Nuten (46).

2. Verfahren nach Anspruch 1, **dadurch gekennzeichnet, dass** es ferner den folgenden letzten Schritt beinhaltet:

   f) Metallisieren (106) des Blocks, um seine Abschirmung zu erzielen.

3. Verfahren nach Anspruch 1 oder 2, das das Erzeugen von Sammelschienen zum Speisen der Module oder Schaltungen beinhaltet, **dadurch gekennzeichnet, dass** in Schritt b) wenigstens eine vorbestimmte der Nuten (45) in das Ende von zwei benachbarten Leitern zum Speisen der Module oder Schaltungen geschnitten wird.

4. Verfahren nach Anspruch 3, **dadurch gekennzeichnet, dass** die zweiten Nuten (46) eine geringere Breite haben als die vorbestimmten Nuten (45).

5. Verfahren nach einem der vorherigen Ansprüche, **dadurch gekennzeichnet, dass** die Nuten (40, 41; 43; 44; 45, 46) mit einer Säge geschnitten werden.

6. Verfahren nach einem der Ansprüche 1 bis 4, **dadurch gekennzeichnet, dass** die Nuten (40, 41; 43; 44; 45, 46) mit einem Laser geschnitten werden.

7. Verfahren nach Anspruch 3 oder 4, **dadurch gekennzeichnet, dass** unmittelbar vor dem Verkapselungsschritt e) ein zusätzlicher Schritt vorgesehen ist:

   h) Einführen eines Kondensators zwischen die seitlichen Flächen von wenigstens einer der vorbestimmten Nuten und Kleben des Kondensators auf jede der seitlichen Flächen mit einem leitenden Klebstoff.

8. Elektronisches Bauelement mit dreidimensionaler Verbindung, umfassend Module oder Schaltungen, die wenigstens eine elektronische Komponente beinhalten und mit Verbindungsleitern versehen sind, wobei die Module oder Schaltungen mit einem elektrisch isolierenden Material gestapelt und verkapselt sind, um einen Block (3, 3') zu bilden, dessen Flächen, die sich an gegenüberliegenden Enden der Leiter befinden, erste Nuten in Kontakt damit umfassen, **dadurch gekennzeichnet, dass** die Enden der Leiter (21; 21') relativ zu den Flächen in Bezug auf den Block zurückgesetzt sind, dadurch, dass die Flächen (302) erste Nuten (40, 41; 43; 44; 45) aufweisen, die tief genug sind, um in die jeweiligen Enden der Leiter (21; 21') zu schneiden, und deren Flächen eine Metallisierung (42) in Kontakt mit den Leitern haben, und dadurch, dass es am Boden dieser ersten Nuten und über ihre gesamte Länge zweite Nuten (46) ohne Metallisierung aufweist, und dadurch, dass der Block ein elektrisch isolierendes Material (303) umfasst, das den gesamten Block (3; 3') und die Nuten verkapselt.

9. Bauelement nach Anspruch 8, **dadurch gekennzeichnet, dass** der Block (3, 3') eine metallische Abschirmungsschicht (304) umfasst, die das elektrisch isolierende Material (303) zum Verkapseln der Baugruppe bedeckt.

10. Bauelement nach Anspruch 8 oder 9, **dadurch gekennzeichnet, dass** die ersten vorbestimmten Nuten (45) in die Enden von zwei benachbarten Leitern (21') schneiden.

11. Bauelement nach Anspruch 10, **dadurch gekennzeichnet, dass** ein Kondensator zwischen den seitlichen Flächen von wenigstens einer der ersten vorbestimmten Nuten (45) vorgesehen ist, wobei der Kondensator mit einem elektrisch leitenden Material an den seitlichen Flächen befestigt ist.


**Claims**

1. A method for the three-dimensional interconnection of packages or circuits that contain at least one electronic component and are provided with connection conductors, wherein said packages or circuits are stacked and consolidated (100) by encapsulation using an electrically insulating material so as to form a block (3, 3'), said method comprising the following steps:

   a) cutting said block;
   b) cutting grooves into the faces of said block that are opposite the ends of said conductors and perpendicular thereto, which grooves come into contact with said conductors;
   c) metallising (103) said block and its grooves;
   d) polishing (104) said faces of said block so as to remove the metallisation from these faces;
   e) encapsulating (105) the entire block with an electrically insulating material;

   said method being **characterised in that** the cutting (101) of step a) is carried out by leaving the ends of said conductors set back relative to the corresponding faces (302) of said block, and **in that** the cutting (102) of the grooves (40, 41; 43, 44) of step b) is carried out over a depth that is sufficient to respectively cut into the end of said conductors, and **in that** it further comprises, between steps c) and e), the insertion of a step of:

   g) cutting (107), in the base and over the entire length of said grooves, second grooves (46).

2. The method according to claim 1, **characterised in that** it further comprises a final step of:

   f) metallising (106) said block so as to provide the shielding thereof.

3. The method according to claim 1 or 2, including the production of omnibus power supply bars for supplying power to said packages or circuits, **characterised in that**, during step b), at least one predetermined groove of said grooves (45) cuts into the end of two adjacent conductors for supplying power to said packages or circuits.

4. The method according to claim 3, **characterised in that** said second grooves (46) are not as wide as said predetermined grooves (45).

5. The method according to any one of the preceding claims, **characterised in that** said grooves (40, 41; 43, 44; 45, 46) are cut by sawing.

6. The method according to any one of claims 1 to 4, **characterised in that** said grooves (40, 41; 43, 44; 45, 46) are cut using a laser.

7. The method according to claim 3 or 4, **characterised in that**, just before said encapsulation step e), provision is made for an additional step of:

   h) introducing a capacitor between the lateral faces of at least one of said predetermined grooves and bonding said capacitor onto each of said lateral faces using a conductive adhesive.

8. An electronic device with three-dimensional interconnection, comprising packages or circuits that contain at least one electronic component and are provided with connection conductors, wherein said packages or circuits are stacked and encapsulated with an electrically insulating material so as to form a block (3, 3'), with the faces of said block that are located opposite ends of said conductors comprising first grooves in contact therewith, **characterised in that** the ends of said conductors (21; 21') are set back relative to said faces opposite said block, **in that** said faces (302) comprise first grooves (40, 41; 43; 44; 45) that are deep enough to cut into the respective ends of said conductors (21; 21') and the faces of which have a metallisation (42) in contact with said conductors, and **in that** it comprises, at the base of said first grooves and over their entire length, second grooves (46) without metallisation, and **in that** said block comprises an electrically insulating material (303) encapsulating the entire block (3; 3') and said grooves.

9. The device according to claim 8, **characterised in that** said block (3, 3') further comprises a metal shielding layer (304) covering said electrically insulating material (303) for encapsulating the assembly.

10. The device according to claim 8 or 9, **characterised in that** first predetermined grooves (45) cut into the ends of two adjacent conductors (21').

11. The device according to claim 10, **characterised in that** a capacitor is provided between the lateral faces of at least one of said first predetermined grooves (45), which capacitor is fixed to said lateral faces using an electrically conducting material.

FIG. 1

DÉTAIL A
FIG.2

FIG.3

FIG.5

100 — EMPILEMENT / SOLIDARISATION DES BOÎTIERS (ENROBAGE + POLYMÉRISATION)

101 — 1er SCIAGE: DÉCOUPE DU BLOC AVEC CONDUCTEURS EN RETRAIT

102 — 2ème SCIAGE: RAINURES DANS LA FACE EN VIS-À-VIS DES CONDUCTEURS

103 — MÉTALLISATION DE L'ENSEMBLE BLOC ET RAINURES

104 — POLISSAGE DES FACES DU BLOC PORTANT LES RAINURES

105 — ENROBAGE DE RÉSINE

106 — MÉTALLISATION POUR BLINDAGE

# FIG.4

FIG.6

FIG.7A

FIG.7B

```
100 ──┐  ┌─────────────────────────────┐
       │  │   EMPILEMENT / SOLIDARISATION │
       └─►│       DES  BOÎTIERS          │
          │  (ENROBAGE + POLYMÉRISATION) │
          └─────────────────────────────┘
```

100 — EMPILEMENT / SOLIDARISATION DES BOÎTIERS (ENROBAGE + POLYMÉRISATION)

101 — 1er SCIAGE: DÉCOUPE DU BLOC AVEC CONDUCTEURS EN RETRAIT

102 — 2ème SCIAGE: RAINURES DANS LA FACE EN VIS-A-VIS DES CONDUCTEURS

103 — MÉTALLISATION DE L'ENSEMBLE BLOC ET RAINURES

104 — POLISSAGE DES FACES DU BLOC PORTANT LES RAINURES

107 — 3ème SCIAGE: RAINURES PLUS ÉTROITES DANS LE FOND DES 1ères RAINURES

COLLAGE DES DEUX FACES DU CONDENSATEUR

108

105 — ENROBAGE DE RÉSINE

106 — MÉTALLISATION POUR BLINDAGE

FIG.8

13

FIG.9

FIG.10

FIG.11

FIG.12

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2670323

- FR 2688630